# EUROPEAN PATENT APPLICATION

(11) **EP 3 588 583 A1**
(43) Date of publication of application: **01.01.2020**
(21) Application number: 17898860.6
(22) Date of filing: 07.06.2017
(51) Int. Cl.: H01L 31/0224, H01L 31/068, H01L 31/18

(54) **P-TYPE PERC DOUBLE-SIDED SOLAR CELL AND MODULE AND SYSTEM THEREOF, AND PREPARATION METHOD THEREFOR**

(30) Priority: 03.03.2017 CN 201710122403
(71) Applicant: Guangdong Aiko Solar Energy Technology Co., Ltd, Foshan, Guangdong 528000 (CN); Zhejiang Aiko Solar Energy Technology Co., Ltd, Yiwu, Zhejiang 322009 (CN)
(72) Inventor: LIN, Kang-Cheng, Foshan, Guangdong 528000 (CN); FANG, Jiebin, Foshan, Guangdong 528000 (CN); CHEN, Gang, Foshan, Guangdong 528000 (CN)
(74) Representative: Steinbauer, Florian
(86) International application number: PCT/CN2017/087361
(87) International publication number: WO 2018/157498

(57) **Abstract**

The present invention discloses a bifacial P-type PERC solar cell, which consecutively comprises a rear silver electrode, rear aluminum grid lines, a rear surface passivation layer, a P-type silicon, an N-type emitter, a front surface silicon nitride film, and a front silver electrode; a laser grooving region is formed at the rear surface passivation layer by laser grooving; the rear aluminum grid lines are connected to the P-type silicon via the laser grooving region; the laser grooving region includes a plurality of sets of laser grooving units arranged horizontally; each of the sets of laser grooving units includes one or more laser grooving bodies arranged horizontally; the rear aluminum grid lines are perpendicular to the laser grooving bodies. The present invention is simple in structure, low in cost, widely applicable, and has a high photoelectric conversion efficiency.

## Description

### FIELD OF THE INVENTION

The present invention relates to the field of solar cells, and in particular to a bifacial P-type PERC solar cell, a method for preparing the bifacial P-type PERC solar cell, a solar cell module that employs the bifacial P-type PERC solar cell, and a solar cell system that employs the bifacial P-type PERC solar cell.

### BACKGROUND OF THE INVENTION

A crystalline silicon solar cell is a device that effectively absorbs solar radiation energy and converts light energy into electrical energy through the photovoltaic effect. When sunlight reaches the p-n junction of a semiconductor, new electron-hole pairs are formed. Under the action of the electric field at the p-n junction, the holes flow from the N zone to the P zone, and the electrons flow from the P zone to the N zone, generating current in a connected circuit.

In a conventional crystalline silicon solar cell, surface passivation is basically only performed at the front surface, which involves depositing a layer of silicon nitride on the front surface of the silicon wafer via PECVD to reduce the recombination rate of the minority carriers at the front surface. As a result, the open-circuit voltage and short-circuit current of the crystalline silicon solar cell are greatly increased, which leads to an increase of the photoelectric conversion efficiency of the crystalline silicon solar cell. However, as passivation is not performed at the rear surface of the silicon wafer, the increase in photoelectric conversion efficiency is limited.

The structure of a bifacial solar cell of the prior art is as follows: the substrate is an N-type silicon wafer. When photons from the sun reach the rear surface of the cell, the carriers generated in the N-type silicon wafer pass through the silicon wafer, which has a thickness of about 200 µm. As in an N-type silicon wafer, the minority carriers tend to have a long lifetime and carrier recombination rate tends to be low, some carriers are able to reach the p-n junction at the front surface. In addition, the front surface of the solar cell is its main light-receiving surface; its conversion efficiency accounts for a high proportion of the conversion efficiency of the whole cell. As a result of light absorption at both the front surface and the rear surface, the conversion efficiency of the cell is significantly increased. However, the price of an N-type silicon wafer is high, and the process of manufacturing a bifacial N-type cell is complicated. In view of these drawbacks, a research hotspot for enterprises and researchers is to develop a bifacial solar cell with high efficiency and low cost.

In order to meet the ever-rising requirements for the photoelectric conversion efficiency of crystalline silicon cells, the industry has been researching rear-surface passivation techniques for PERC solar cells. Mainstream manufacturers in the industry are mainly developing monofacial PERC solar cells. The present invention combines a highly efficient PERC cell and a bifacial cell to develop a bifacial PERC solar cell that has a higher photoelectric conversion efficiency.

Bifacial PERC solar cells have higher practical values as they have high photoelectric conversion efficiency and they absorb solar energy on both sides to generate more power. The present invention aims to provide a bifacial P-type PERC solar cell which is simple to manufacture, low in cost, widely applicable, and has a high photoelectric conversion efficiency.

### SUMMARY OF THE INVENTION

The first objective of the present invention is to provide a bifacial P-type PERC solar cell which is simple in structure, low in cost, widely applicable, and has a high photoelectric conversion efficiency.

The second objective of the present invention is to provide a method of preparing the bifacial P-type PERC solar cell, which is simple, low in cost, widely applicable, and has a high photoelectric conversion efficiency.

The third objective of the present invention is to provide a PERC solar cell module of the bifacial P-type PERC solar cell, which is simple in structure, low in cost, widely applicable, and has a high photoelectric conversion efficiency.

The fourth objective of the present invention is to provide a PERC solar system f the bifacial P-type PERC solar cell, which is simple in structure, low in cost, widely applicable, and has a high photoelectric conversion efficiency.

To achieve the objectives above, the present invention provides a bifacial P-type PERC solar cell, which consecutively comprises a rear silver electrode, a rear aluminum grid line, a rear surface passivation layer, P-type silicon, an N-type emitter, a front surface silicon nitride film, and a front silver electrode;
a laser grooving region is formed at the rear surface passivation layer by laser grooving; the rear aluminum grid lines are connected to the P-type silicon via the laser grooving region;
the laser grooving region includes a plurality of sets of laser grooving units arranged horizontally; each of the sets of laser grooving unit includes one or more laser grooving bodies arranged horizontally; the rear aluminum grid lines are perpendicular to the laser grooving bodies.

As a preferred embodiment, the laser grooving body has a linear shape;
the laser grooving units are arranged in parallel;
in each of the laser grooving units, the laser grooving bodies are arranged side by side; the laser grooving bodies may be on the same horizontal plane or may be staggered up and down.

As a preferred embodiment, a spacing between two adjacent laser grooving units is 0.5-50 mm;
in each of the laser grooving units, a spacing between two adjacent laser grooving bodies is 0.5-50 mm;
each laser grooving body has a length of 50-5000 µm and a width of 10-500 µm.

As a preferred embodiment, 30-500 rear aluminum grid lines are provided; each of the rear aluminum grid lines has a width of 30-500 µm, and the width of the rear aluminum grid line is smaller than the length of each of the laser grooving bodies.

As a preferred embodiment, the rear surface passivation layer includes an aluminum oxide layer and a silicon nitride layer; the aluminum oxide layer is connected to the P-type silicon, the silicon nitride layer is connected to the aluminum oxide layer;
the silicon nitride layer has a thickness of 20 to 500 nm;
the aluminum oxide layer has a thickness of 2 to 50 nm.

Accordingly, the present invention also provides a method of preparing the bifacial P-type PERC solar cell, which comprises the following steps:
S101: forming a textured surface on a front surface and a rear surface of a silicon wafer, the silicon wafer is the P-type silicon;
S102: performing diffusion on the silicon wafer to form the N-type emitter;
S103: removing phosphosilicate glass on the front surface and peripheral p-n junctions formed during the diffusion;
S104: depositing an aluminum oxide film on the rear surface of the silicon wafer;
S105: depositing a silicon nitride film on the rear surface of the silicon wafer;
S106: depositing a silicon nitride film on the front surface of the silicon wafer;
S107: performing laser grooving at the rear surface of the silicon wafer to form the laser grooving region, the laser grooving region comprises the plurality of sets of laser grooving units that are horizontally arranged, each of the sets of the laser grooving unit comprises one or more laser grooving bodies arranged horizontally;
S108: printing rear silver electrode major grid lines on the rear surface of the silicon wafer;
S109: forming the rear aluminum grid lines by printing with aluminum paste in a direction perpendicular to a direction of laser grooving on the rear surface of the silicon wafer; the rear aluminum grid lines are perpendicular to the laser grooving bodies;
S110: printing with positive electrode slurry on the front surface of the silicon wafer;
S111: sintering the silicon wafer at a high temperature to form the rear silver electrode and the front silver electrode;
S112: performing anti-LID annealing on the silicon wafer.

As a preferred embodiment, the method further comprises polishing the rear surface of the silicon wafer between S103 and S104.

As a preferred embodiment, each of the laser grooving bodies has a linear shape;
the laser grooving units are arranged in parallel;
in each of the laser grooving units, the laser grooving bodies are arranged side by side, the laser grooving bodies may be on the same horizontal plane or may be staggered up and down;
a spacing between two adjacent laser grooving units is 0.5-50 mm;
in each of the laser grooving units, a spacing between two adjacent laser grooving bodies is 0.5-50 mm;
each of the laser grooving bodies has a length of 50-5000 µm and a width of 10-500 µm;
30-500 rear aluminum grid lines are provided; each of the rear aluminum grid lines has a width of 30-500 µm, and the width of the rear aluminum grid line is smaller than the length of the laser grooving body.

Accordingly, the present invention also provides a PERC solar cell module, which includes a PERC solar cell and a packaging material, wherein the PERC solar cell is any one of the bifacial P-type PERC solar cells described above.

Accordingly, the present invention also provides a PERC solar system, which comprises a PERC solar cell, wherein the PERC solar cell is any one of the bifacial P-type PERC solar cells described above.

The beneficial effects of the present invention are as follows:
In the present invention, after a rear surface passivation layer is formed, laser grooving is performed on the rear surface passivation layer to form a laser grooving region. Then, rear aluminum grid lines are formed by printing with aluminum paste along the direction perpendicular to the direction of laser grooving so that the aluminum paste is connected to the P-type silicon via the laser grooving region. The bifacial P-type PERC solar cell is provided with grid line structures on both the rear surface and the front surface of the silicon wafer. The printing of aluminum paste is different from the conventional method. As the width of the rear aluminum grid line is much smaller than the length of the laser grooving body, precise alignment of the aluminum paste and the laser grooving region is not necessary, which simplifies the laser process and the printing process, reduces the difficulties in setting up the printing equipment, and is easy to scale-up for industrial production. Furthermore, the laser grooving region that is not covered by the aluminum paste allows increased sunlight absorption at the rear surface of the cell, thus increases the photoelectric conversion efficiency of the cell. To summarize, the present invention is simple in structure, easy to manufacture, low in cost, widely applicable, and has a high photoelectric conversion efficiency.

### BRIEF DESCRIPTION OF THE DRAWINGS

FIG. 1 is a sectional view of the bifacial P-type PERC solar cell of the present invention.
FIG. 2 is a schematic diagram of the rear surface structure of the bifacial P-type PERC solar cell of the present invention.
FIG. 3 is a schematic diagram of an embodiment of the laser grooving region of the bifacial P-type PERC solar cell of the present invention.
FIG. 4 is a schematic diagram of another embodiment of the laser grooving region of the bifacial P-type PERC solar cell of the present invention.

### DETAILED DESCRIPTION OF THE ILLUSTRATED EMBODIMENTS

To more clearly illustrate the objectives, technical solutions and beneficial of the present invention, the present invention will be further described in detail with reference to the accompanying drawings.

An existing monofacial solar cell has an aluminum back surface field on the rear surface of the cell and covering the entire rear surface of the silicon wafer. The aluminum back surface field increases the open-circuit voltage Voc and the short-circuit current Jsc, forces the minority carriers away from the surface, decreases the recombination rate of the minority carriers, leading to increased cell efficiency. However, as the aluminum back surface field is opaque, the rear surface of the solar cell, which is provided with the aluminum back surface field, cannot absorb light energy; light energy can only be absorbed in the front surface. Consequentially, it is difficult to significantly improve the overall photoelectric conversion efficiency of the cell.

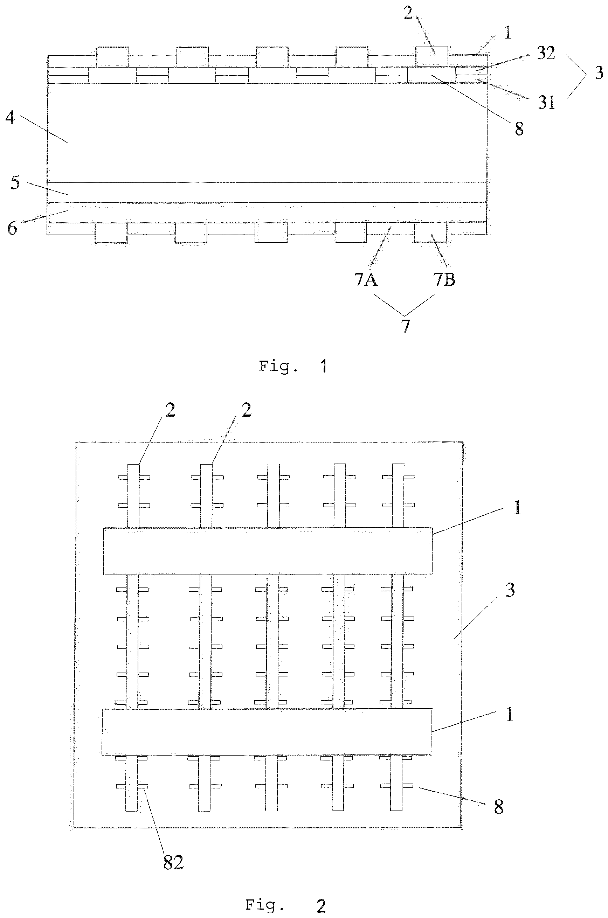

In view of the technical problem above, referring to FIG. 1, the present invention provides a bifacial P-type PERC solar cell, which consecutively includes a rear silver electrode 1, rear aluminum grid lines 2, a rear surface passivation layer 3, a P-type silicon 4, an N-type emitter 5, a front surface silicon nitride film 6, and a front silver electrode 7. A laser grooving region 8 is formed at the rear surface passivation layer 3 by laser grooving. The rear aluminum grid lines 2 are connected to the P-type silicon 4 via the laser grooving region 8. The front silver electrode 7 includes front silver electrode major grid lines 7A and front silver electrode minor grid lines 7B. The rear surface passivation layer 3 includes an aluminum oxide layer 31 and a silicon nitride layer 32.

The present invention improves on the basis of existing monofacial PERC solar cells. A plurality of rear aluminum grid lines 2 are provided instead of an aluminum back surface field. Laser grooving regions 8 are formed at the rear surface passivation layer 3 by laser grooving, and rear aluminum grid lines 2 are printed on these parallel-arranged laser grooving regions 8 to be in local contact with the P-type silicon 4. The closely and parallelly arranged rear aluminum grid lines 2 could increase the open-circuit voltage Voc and the short-circuit current Jsc, reduce the recombination rate of the minority carriers, thus increase the photoelectric conversion efficiency of the cell; they could replace the aluminum back surface field of the existing monofacial cell. In addition, the rear aluminum grid lines 2 do not completely cover the rear side of the silicon wafer, and thus sunlight could reach the inside of the silicon wafer through the gaps between rear aluminum grid lines 2. In this way, the absorption of light energy at the rear side of the silicon wafer can be achieved, which greatly improves the photoelectric conversion efficiency of the cell.

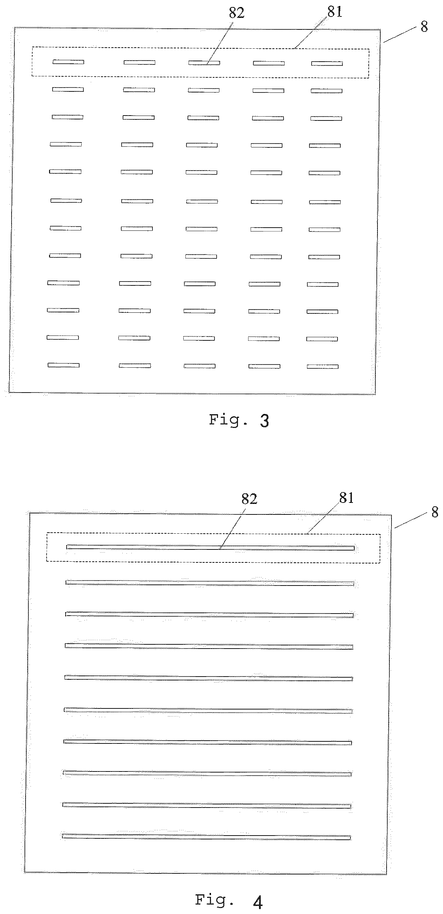

As shown in FIG. 2, the laser grooving region 8 includes a plurality of sets of laser grooving units 81 arranged horizontally; each of the sets of laser grooving units 81 includes one or more laser grooving bodies 82 arranged horizontally. The rear aluminum grid lines 2 are perpendicular to the laser grooving body 82. Referring to FIGS. 3 and 4, the structure enclosed by the dashed rectangle in FIGS. 3 and 4 is the laser grooving unit 81, each laser grooving unit 81 includes one or more laser grooving bodies 82 arranged horizontally.

It should be noted that the laser grooving unit 81 could have various possible embodiments, including the following:
(1) Each laser grooving unit 81 includes one laser grooving body 82 disposed along the horizontal direction. In this case, the laser grooving unit 81 is a continuous linear grooving region as shown in FIG. 4. A plurality of laser grooving units 81 are arranged along the perpendicular direction.
(2) Each laser grooving unit 81 includes a plurality of laser grooving bodies 82 disposed along the horizontal direction. In this case, the laser grooving unit 81 is a non-continuous, line-segment-type linear grooving region as shown in FIG 3. The plurality of laser grooving bodies 82 may be two, three, four or more laser grooving bodies 82, but are not limited thereto. A plurality of laser grooving units 81 are arranged along the perpendicular direction.

When each of the laser grooving units 81 includes a plurality of laser grooving bodies 82 arranged horizontally, there are a few possibilities:
A. The width, length, and shape of the plurality of the horizontally arranged laser grooving bodies 82 are the same. Their dimensions are in the order of micrometers; their length may be 50-5000 micrometers but are not limited thereto. it should be noted that the laser grooving bodies may be on the same horizontal plane, or may be staggered up and down (i.e., not on the same horizontal plane). The topography of the staggered arrangement depends on production needs.
B. The width, length, and shape of the plurality of horizontally arranged laser grooving bodies 82 are the same. Their dimensions are in the order of millimeters; their length may be 5 to 600 millimeters but is not limited thereto. It should be noted that the laser grooving bodies may be on the same horizontal plane, or may be staggered up and down (i.e., not on the same horizontal plane). The topography of the staggered arrangement depends on production needs.
C. The width, length, and/or shape of the plurality of horizontally arranged laser grooving bodies 82 are different; they can be designed together according to production needs. It should be noted that the laser grooving bodies may be on the same horizontal plane, or may be staggered up and down (i.e., not on the same horizontal plane). The topography of the staggered arrangement depends on production needs.

As a preferred embodiment of the present invention, the laser grooving body has a linear shape. This shape is easy to process, simplifies the manufacturing process, and reduces manufacture costs. The laser grooving body may also adopt other shapes, such as a curved shape, an arc shape, a wavy shape, etc.; their embodiments are not limited to the embodiments presented in this invention.

The laser grooving units are arranged in parallel. In each laser grooving unit, the laser grooving bodies are arranged side by side. This simplifies the production process and is widely applicable.

The spacing between two adjacent laser grooving units is 0.5-50 mm. In each laser grooving unit, the spacing between two adjacent laser grooving bodies is 0.5-50 mm.

The laser grooving body 82 has a length of 50-5000 µm and a width of 10-500 µm. Preferably, the laser grooving body 82 has a length of 250-1200 µm and a width of 30-80 µm.

The length, width, and spacing of the laser grooving unit and the number and width of the aluminum grid lines are optimized by taking the following factors into account: the contact area of the aluminum grid lines and the P-type silicon, the shading area of the aluminum grid lines, and fully collecting electrons. The aim of the optimization is to reduce the shading area of the rear aluminum grid lines as much as possible while allowing good current output, thus increasing the overall photoelectric conversion efficiency of the cell.

The number of the rear aluminum grid lines is 30-500; the width of the rear aluminum grid lines is 30-500 µm, and the width of these rear aluminum grid lines is much smaller than the length of the laser grooving body. Preferably, the number of the rear aluminum grid lines is 80-220, and the width of the rear aluminum grid lines is 50-300 µm.

The width of the rear aluminum grid line is much smaller than the length of the laser grooving body. When the aluminum grid line is perpendicular to the laser grooving body, the printing of the rear aluminum grid lines is much more convenient. The aluminum grid lines can be printed in the laser grooving region without precise alignment, which simplifies the laser process and the printing process, reduces the difficulties in setting up the printing equipment, and is easy for industrial scale-up.

The invention forms a laser grooving region by treating the rear surface passivation layer with laser grooving, and then prints with aluminum paste in a direction that is perpendicular to the direction of the laser grooving lines so that the aluminum paste is connected to the P-type silicon through the grooving region to form the rear aluminum grid lines. The bifacial PERC solar cell is provided with grid lines at the front and rear surfaces of the silicon wafer. The method of printing with aluminum paste employed in this invention is different from the conventional method in that the precise alignment of the aluminum paste with the laser grooving region is not necessary. This process is simple and easy for industrial scale-up. If the aluminum grid lines were parallel to the laser grooving body, the aluminum paste and the laser slotted area would need to be accurately aligned, which would place high requirements on the precision and repeatability of the printing equipment; as a result, the yield would be difficult to control and a lot of defective products would be produced, resulting in decreased average photoelectric conversion efficiency. With the present invention, the yield can be increased to 99.5%.

In addition, the rear surface passivation layer 3 includes an aluminum oxide layer 31 and a silicon nitride layer 32. The aluminum oxide layer 31 is connected to the P-type silicon 4, the silicon nitride layer 32 is connected to the aluminum oxide layer 31.

The silicon nitride layer 32 has a thickness of 20 to 500 nm.

The aluminum oxide layer 31 has a thickness of 2 to 50 nm.

Preferably, the silicon nitride layer 32 has a thickness of 100-200 nm.

The aluminum oxide layer 31 has a thickness of 5 to 30 nm.

The present invention also discloses a method for preparing a bifacial P-type PERC solar cell, comprising the following steps:
S101: forming a textured surface on the front and rear surfaces of the silicon wafer, the silicon wafer is P-type silicon;
S102: performing diffusion on the silicon wafer to form an N-type emitter;
S103: removing the phosphosilicate glass on the front surface and peripheral p-n junctions formed during the diffusion;
S104: depositing an aluminum oxide film on the rear surface of the silicon wafer;
S105: depositing a silicon nitride film on the rear surface of the silicon wafer;
S106: depositing a silicon nitride film on the front surface of the silicon wafer;
S107: performing laser grooving at the rear surface of the silicon wafer to form a laser grooving region, the laser grooving region comprises a plurality of sets of horizontally arranged laser grooving units, each of the sets of laser grooving units comprises one or more horizontally arranged laser grooving body;
S108: printing rear silver electrode major grid lines on the rear surface of the silicon wafer;
S109: forming rear aluminum grid lines by printing with aluminum paste in a direction perpendicular to the direction of laser grooving on the rear surface of the silicon wafer; the rear aluminum grid lines are perpendicular to the laser grooving body;
S110: printing with a positive electrode slurry on the front surface of the silicon wafer;
Sill: sintering the silicon wafer at a high temperature to form a rear silver electrode and a front silver electrode;
S112: performing anti-LID annealing on the silicon wafer.

It should be noted that the order of S106 and S104, S105 can be interchanged: S106 can be performed before S104 and S105.

Between S103 and S104, the method further comprises polishing the rear surface of the silicon wafer. The present invention may or may not comprise this rear surface polishing step.

It should also be noted that the specific parameter settings of the laser grooving region and the rear aluminum grid lines in the preparation method are as described above and is thus not described again here.

Accordingly, the present invention also provides a PERC solar cell module, which includes a PERC solar cell and a packaging material; the PERC solar cell is any one of the bifacial P-type PERC solar cells described above. Specifically, as one embodiment of the PERC solar cell module, it is composed of a first layer of high-transmittance tempered glass, a first layer of ethylene-vinyl acetate (EVA) copolymer, a PERC solar cell, a second layer of an ethylene-vinyl acetate (EVA) copolymer, and a second layer of high-transmittance tempered glass which are sequentially connected from top to bottom.

The present invention also provides a PERC solar system, comprising a PERC solar cell, the PERC solar cell is any one of the bifacial P-type PERC solar cells described above. As a preferred embedment of the PERC solar cell system, it comprises a PERC solar cell, a rechargeable battery pack, a charge and discharge controller, an inverter, an AC power distribution cabinet, and a sun-tracking control system. The PERC solar cell system may or may not comprise a rechargeable battery pack, a charge and discharge controller, and an inverter. Those skilled in the art can adopt different settings according to actual needs.

It should be noted that in the PERC solar cell module and the PERC solar system, components other than the bifacial P-type PERC solar cell may be designed with reference to the prior art.

The present invention will be described in detail with reference to embodiments.

### EMBODIMENT 1

(1) forming a textured surface on the front and rear surfaces of the silicon wafer, the silicon wafer is P-type silicon;
(2) performing diffusion on the silicon wafer to form an N-type emitter;
(3) removing the phosphosilicate glass on the front surface and peripheral p-n junctions formed during the diffusion;
(4) depositing an aluminum oxide film on the rear surface of the silicon wafer;
(5) depositing a silicon nitride film on the rear surface of the silicon wafer;
(6) depositing a silicon nitride film on the front surface of the silicon wafer;
(7) performing laser grooving at the rear surface of the silicon wafer to form a laser grooving region, the laser grooving region comprises a plurality of sets of horizontally arranged laser grooving units, each of the sets of laser grooving units comprises one or more horizontally arranged laser grooving body; the laser grooving body has a length of 1000 µm and a width of 40 µm;
(8) printing rear silver electrode major grid lines on the rear surface of the silicon wafer;
(9) forming rear aluminum grid lines by printing with aluminum paste along the direction perpendicular to the direction of laser grooving on the rear surface of the silicon wafer; the rear aluminum grid lines are perpendicular to the laser grooving body; the number of the rear aluminum grid lines is 150, the width of the rear aluminum grid lines is 150 µm;
(10) printing with a positive electrode slurry on the front surface of the silicon wafer;
(11) sintering the silicon wafer at a high temperature to form a rear silver electrode and a front silver electrode;
(12) performing anti-LID annealing on the silicon wafer.

### EMBODIMENT 2

(1) forming a textured surface on the front and rear surfaces of the silicon wafer, the silicon wafer is P-type silicon;
(2) performing diffusion on the silicon wafer to form an N-type emitter;
(3) removing the phosphosilicate glass on the front surface and peripheral p-n junctions formed during the diffusion; polishing the rear surface of the silicon wafer;
(4) depositing an aluminum oxide film on the rear surface of the silicon wafer;
(5) depositing a silicon nitride film on the rear surface of the silicon wafer;
(6) depositing a silicon nitride film on the front surface of the silicon wafer;
(7) performing laser grooving at the rear surface of the silicon wafer to form a laser grooving region, the laser grooving region comprises a plurality of sets of horizontally arranged laser grooving units, each of the sets of laser grooving units comprises one or more horizontally arranged laser grooving body; the laser grooving body has a length of 500 µm and a width of 50 µm;
(8) printing rear silver electrode major grid lines on the rear surface of the silicon wafer;
(9) forming rear aluminum grid lines by printing with aluminum paste along the direction perpendicular to the direction of laser grooving on the rear surface of the silicon wafer; the rear aluminum grid lines are perpendicular to the laser grooving body; the number of the rear aluminum grid lines is 200, the width of the rear aluminum grid lines is 200 µm;
(10) printing with a positive electrode slurry on the front surface of the silicon wafer;
(11) sintering the silicon wafer at a high temperature to form a rear silver electrode and a front silver electrode;
(12) performing anti-LID annealing on the silicon wafer.

### EMBODIMENT 3

(1) forming a textured surface on the front and rear surfaces of the silicon wafer, the silicon wafer is P-type silicon;
(2) performing diffusion on the silicon wafer to form an N-type emitter;
(3) removing the phosphosilicate glass on the front surface and peripheral p-n junctions formed during the diffusion;
(4) depositing an aluminum oxide film on the rear surface of the silicon wafer;
(5) depositing a silicon nitride film on the rear surface of the silicon wafer;
(6) depositing a silicon nitride film on the front surface of the silicon wafer;
(7) performing laser grooving at the rear surface of the silicon wafer to form a laser grooving region, the laser grooving region comprises a plurality of sets of horizontally arranged laser grooving units, each of the sets of laser grooving units comprises one or more horizontally arranged laser grooving body; the laser grooving body has a length of 300 µm and a width of 30 µm;
(8) printing rear silver electrode major grid lines on the rear surface of the silicon wafer;
(9) forming rear aluminum grid lines by printing with aluminum paste along the direction perpendicular to the direction of laser grooving on the rear surface of the silicon wafer; the rear aluminum grid lines are perpendicular to the laser grooving body; the number of the rear aluminum grid lines is 250, the width of the rear aluminum grid lines is 250 µm;
(10) printing with a positive electrode slurry on the front surface of the silicon wafer;
(11) sintering the silicon wafer at a high temperature to form a rear silver electrode and a front silver electrode;
(12) performing anti-LID annealing on the silicon wafer.

### EMBODIMENT 4

(1) forming a textured surface on the front and rear surfaces of the silicon wafer, the silicon wafer is P-type silicon;
(2) performing diffusion on the silicon wafer to form an N-type emitter;
(3) removing the phosphosilicate glass on the front surface and peripheral p-n junctions formed during the diffusion; polishing the rear surface of the silicon wafer
(4) depositing an aluminum oxide film on the rear surface of the silicon wafer;
(5) depositing a silicon nitride film on the rear surface of the silicon wafer;
(6) depositing a silicon nitride film on the front surface of the silicon wafer;
(7) performing laser grooving at the rear surface of the silicon wafer to form a laser grooving region, the laser grooving region comprises a plurality of sets of horizontally arranged laser grooving units, each of the sets of laser grooving units comprises one or more horizontally arranged laser grooving body; the laser grooving body has a length of 1200 µm and a width of 200 µm;
(8) printing rear silver electrode major grid lines on the rear surface of the silicon wafer;
(9) forming rear aluminum grid lines by printing with aluminum paste along the direction perpendicular to the direction of laser grooving on the rear surface of the silicon wafer; the rear aluminum grid lines are perpendicular to the laser grooving body; the number of the rear aluminum grid lines is 300, the width of the rear aluminum grid lines is 300 µm;
(10) printing with a positive electrode slurry on the front surface of the silicon wafer;
(11) sintering the silicon wafer at a high temperature to form a rear silver electrode and a front silver electrode;
(12) performing anti-LID annealing on the silicon wafer.

It should be noted that the above embodiments are only intended to illustrate the technical solutions of the present invention and are not intended to limit the scope of the present invention. Although the present invention has been described in detail with reference to the preferred embodiments, the technical solutions of the present invention may be modified or equivalently substituted without departing from the spirit and scope of the technical solutions of the present invention.

## Claims

1. A bifacial P-type PERC solar cell, wherein it consecutively comprises a rear silver electrode, a rear aluminum grid line, a rear surface passivation layer, P-type silicon, an N-type emitter, a front surface silicon nitride film, and a front silver electrode;
a laser grooving region is formed at the rear surface passivation layer by laser grooving; the rear aluminum grid lines are connected to the P-type silicon via the laser grooving region;
the laser grooving region includes a plurality of sets of laser grooving units arranged horizontally; each of the set of laser grooving units includes one or more laser grooving bodies arranged horizontally; the rear aluminum grid lines are perpendicular to the laser grooving bodies.

2. The bifacial P-type PERC solar cell according to claim 1, wherein the laser grooving units are arranged in parallel;
in each of the laser grooving units, the laser grooving bodies are arranged side by side; the laser grooving bodies may be on the same horizontal plane or may be staggered up and down.

3. The bifacial P-type PERC solar cell according to claim 1, wherein a spacing between two adjacent laser grooving units is 0.5-50 mm;
in each of the laser grooving units, a spacing between two adjacent laser grooving bodies is 0.5-50 mm;
each laser grooving body has a length of 50-5000 µm and a width of 10-500 µm.

4. The bifacial P-type PERC solar cell according to claim 1, wherein 30-500 rear aluminum grid lines are provided; each of the rear aluminum grid lines has a width of 30-500 µm, and the width of the rear aluminum grid line is smaller than the length of each of the laser grooving bodies.

5. The bifacial P-type PERC solar cell according to claim 1, wherein the rear surface passivation layer includes an aluminum oxide layer and a silicon nitride layer; the aluminum oxide layer is connected to the P-type silicon, the silicon nitride layer is connected to the aluminum oxide layer;
the silicon nitride layer has a thickness of 20 to 500 nm;
the aluminum oxide layer has a thickness of 2 to 50 nm.

6. A method of preparing the bifacial P-type PERC solar cell according to any one of claims 1-5, wherein it comprises the following steps:
S101: forming a textured surface on a front surface and a rear surface of a silicon wafer, the silicon wafer is the P-type silicon;
S102: performing diffusion on the silicon wafer to form the N-type emitter;
S103: removing phosphosilicate glass on the front surface and peripheral p-n junctions formed during the diffusion;
S104: depositing an aluminum oxide film on the rear surface of the silicon wafer;
S105: depositing a silicon nitride film on the rear surface of the silicon wafer;
S106: depositing a silicon nitride film on the front surface of the silicon wafer;
S107: performing laser grooving at the rear surface of the silicon wafer to form the laser grooving region, the laser grooving region comprises the plurality of sets of laser grooving units that are horizontally arranged, each of the sets of laser grooving units comprises one or more laser grooving bodies arranged horizontally;
S108: printing rear silver electrode major grid lines on the rear surface of the silicon wafer;
S109: forming the rear aluminum grid lines by printing with aluminum paste in a direction perpendicular to a direction of laser grooving on the rear surface of the silicon wafer; the rear aluminum grid lines are perpendicular to the laser grooving bodies;
S110: printing with positive electrode slurry on the front surface of the silicon wafer;
Sill: sintering the silicon wafer at a high temperature to form the rear silver electrode and the front silver electrode;
S112: performing anti-LID annealing on the silicon wafer.

7. The method according to claim 6, wherein the method further comprises polishing the rear surface of the silicon wafer between S103 and S104.

8. The method according to claim 7, wherein each of the laser grooving bodies has a linear shape;
the laser grooving units are arranged in parallel;
in each of the laser grooving units, the laser grooving bodies are arranged side by side, the laser grooving bodies may be on the same horizontal plane or may be staggered up and down;
a spacing between two adjacent laser grooving units is 0.5-50 mm;
in each of the laser grooving units, a spacing between two adjacent laser grooving bodies is 0.5-50 mm;
each of the laser grooving bodies has a length of 50-5000 µm and a width of 10-500 µm;
30-500 rear aluminum grid lines are provided; each of the rear aluminum grid lines has a width of 30-500 µm, and the width of the rear aluminum grid line is smaller than the length of the laser grooving body.

9. A PERC solar cell module, wherein it includes a PERC solar cell and a packaging material, wherein the PERC solar cell is the bifacial P-type PERC solar cell according to any one of claims 1-5.

10. A PERC solar system, comprising a PERC solar cell, wherein the PERC solar cell is the bifacial P-type PERC solar cell according to any one of claims 1-5.
